# EUROPEAN PATENT APPLICATION

(11) **EP 2 608 212 A1**
(43) Date of publication of application: **26.06.2013**
(21) Application number: 12189223.6
(22) Date of filing: 19.10.2012
(51) Int. Cl.: G11C 29/40, G11C 29/44

(54) **Semiconductor integrated circuit and method of testing semiconductor integrated circuit**

(30) Priority: 21.12.2011 JP 2011280528
(71) Applicant: FUJITSU LIMITED, Kawasaki-shi, Kanagawa 211-8588 (JP)
(72) Inventor: Yanagida, Masahiro, Kanagawa, 211-8588 (JP); Fujimoto, Hiroyuki, Kanagawa, 211-8588 (JP); Yamanaka, Hitoshi, Kanagawa, 211-8588 (JP)
(74) Representative: HOFFMANN EITLE

(57) **Abstract**

A semiconductor integrated circuit includes a plurality of memory cells, a plurality of receivers, each of the plurality of receivers being provided for a corresponding one of a plurality of units set by dividing the plurality of memory cells in a unit, and each of the plurality of receivers receiving a test result of the corresponding one of the plurality of units, and a controller that reads out a plurality of test results from the plurality of receivers.

## Description

### FIELD

The embodiments discussed herein are related to a semiconductor integrated circuit and a method of testing a semiconductor integrated circuit.

### BACKGROUND

In recent years, the degree of integration of semiconductor integrated devices, such as large scale integrated circuits (LSIs), has been increasing, and the capacity of random access memories (RAMs) in which an LSI includes many memory cells has been increasing.

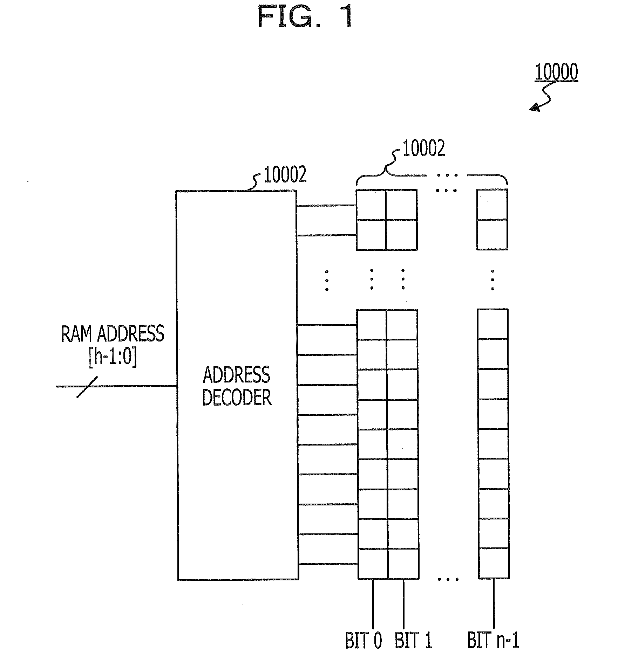

FIG. 1 illustrates a configuration of a RAM 10000 according to the related art.

The RAM 10000 includes many memory cells 10001 arranged, each storing one-bit information. Access to the individual memory cells 10001 is performed by an address decoder 10002. For example, access to the data stored in the RAM 10000 is performed in units of plural bits (n-bit strings). Each of the n-bit strings has an address (RAM address) assigned thereto. When a RAM address is input to the address decoder 10002, the address decoder 10002 outputs an access signal to each of the memory cells 10001 in the n-bit string corresponding to the input RAM address. Accordingly, the n-bit string corresponding to the RAM address may be accessed.

For example, the RAM 10000 include n-bit (n may be 32, 64, 128) strings arranged therein, and each of the n-bit strings be coupled to the address decoder 10002. Thus, according to the related art, as illustrated in FIG. 1, the memory cells 10001 in the individual n-bit strings are arranged so that the memory cells of the same bit are aligned, and lines from the address decoder 10002 are coupled to the memory cells 10001 in the respective n-bit strings.

With such an arrangement of memory cells in the configuration according to the related art, n (the number of bits in an n-bit string) x h (the number of memory-cell addresses h) memory cells are arranged.

In recent years, the capacity of RAMs has been increasing, and the number of memory-cells n x h has become one million or more. Therefore, if n-bit strings corresponding to the memory-cell addresses h are arranged, as described above, the region of the n-bit strings becomes long in accordance with the number of memory-cell addresses h. However, the area of a mount region in a semiconductor integrated device is limited, and it is difficult to arrange many memory cells therein.

For this reason, a row-column structure, in which the memory cells of the same bit in the individual n-bit strings are two-dimensionally arranged, has become available in recent years.

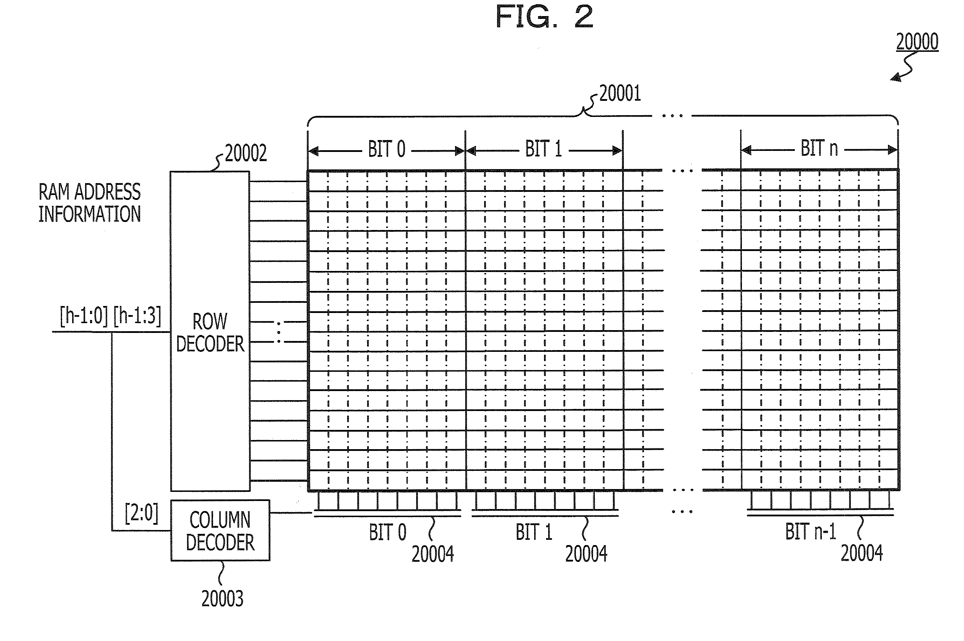

Hereinafter, a RAM 20000 having a row-column structure will be described with reference to FIG. 2.

Referring to FIG. 2, memory cells 20001 are two-dimensionally arranged on a plane. The plane of the memory cells 20001 includes regions of memory cells for individual bits of n-bit strings, as indicated by bit 0 to bit n.

In each of the regions, memory cells corresponding to memory-cell addresses h are two-dimensionally arranged, in row p (eight in FIG. 2) x column c (memory-cell addresses h - p).

A row decoder 20002 is disposed on a row side of the memory cells 20001, and a column decoder 20003 is disposed on a column side thereof.

For example, when there are memory-cell addresses 0000h to FFFFh, each of the addresses is specified as sixteen-bit RAM address information from the outside. The upper thirteen bits of the sixteen-bit RAM address information are input to the row decoder 20002. The row decoder 20002 performs output to a line corresponding to the upper thirteen bits of the input RAM address information.

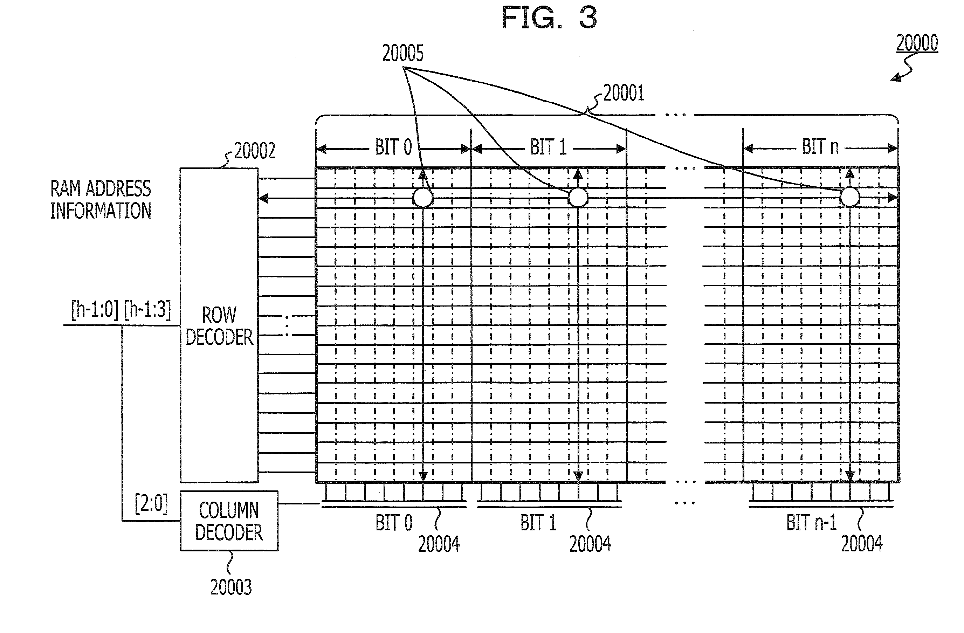

As illustrated in FIG. 3, memory cells 20005 specified by the RAM address information are selected as targets to be accessed, in accordance with control signals output from the row decoder 20002 and the column decoder 20003.

In the above-described RAM 20000, it is preferable that all the arranged memory cells 20001 function. If the RAM 20000 is configured so that a defective memory cell is replaceable with another memory cell, the RAM 20000 may function even if the memory cells 20001 include a defective memory cell.

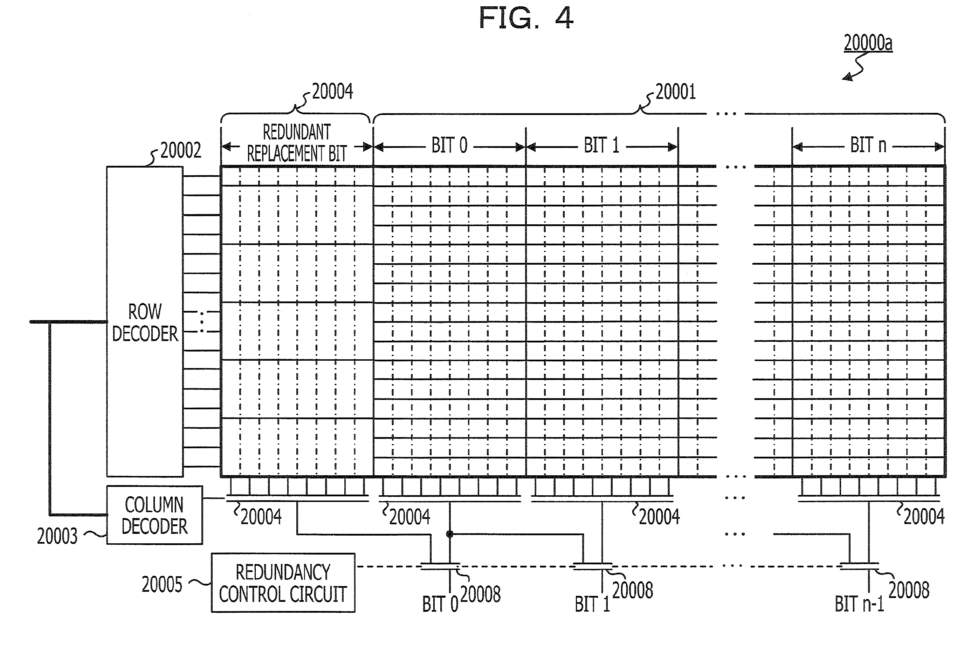

FIG. 4 illustrates a RAM 20000a including redundant memory cells.

In the RAM 20000a illustrated in FIG. 4, a redundant replacement bit 20004 for one bit is added to the configuration illustrated in FIG. 2. Like the other bits, the row decoder 20002 is coupled thereto.

Also, a redundancy control circuit 20007 is coupled to selectors 20008 which are provided along access lines for individual bits.

Each of the selectors 20008 performs, in response to a signal from the redundancy control circuit 20007, switching between access to the memory cells 20001 of the corresponding bit and access to the memory cells of the redundant replacement bit 20004, with respect to an access line of a defective bit.

The redundancy control circuit 20007 stores information indicating the bit the access to the memory cells 20001 of which is to be switched to the access to the memory cells of the redundant replacement bit 20004, and controls the corresponding selector 20008 in accordance with the information.

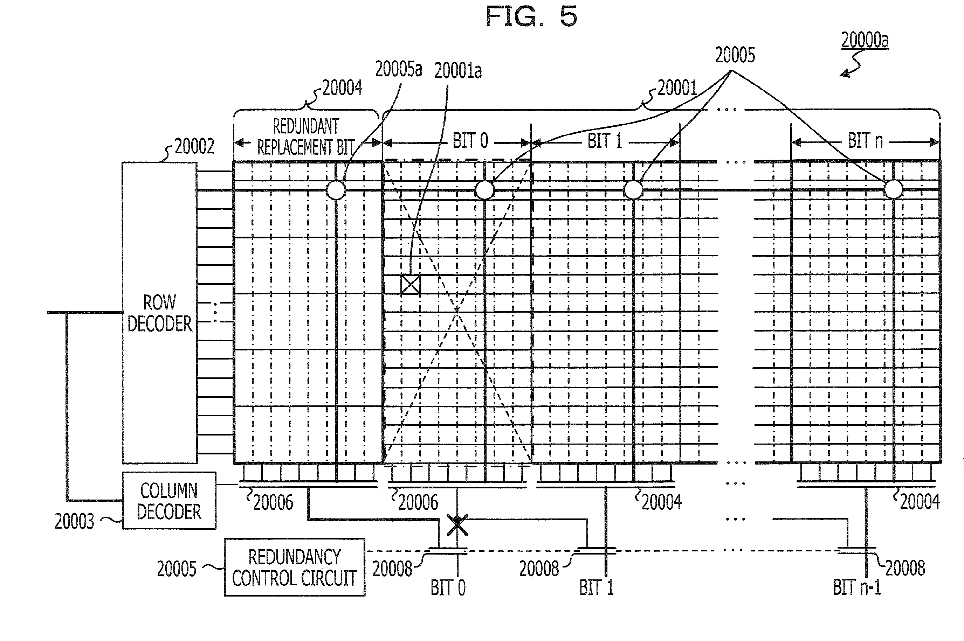

For example, when the redundancy control circuit 20007 controls access to bit 0 as access to the redundant replacement bit 20004, the selector 20008 corresponding to bit 0 performs switching so that access to the redundant replacement bit 20004, not to bit 0, is performed, as illustrated in FIG. 5. The other selectors 20008 perform switching, in response to a signal from the redundancy control circuit 20007, so that access to the memory cells 20001 of the corresponding bits is performed.

With this structure, when there is a defective memory cell 20001a among the memory cells 20001 of the RAM 20000a, as illustrated in FIG. 5, the redundancy control circuit 20007 performs control so that access to the bit having the defective memory cell 20001a is switched to access to the redundant replacement bit 20004. Accordingly, even if there is the defective memory cell 20001a in the RAM 20000a, the RAM 20000a may function.

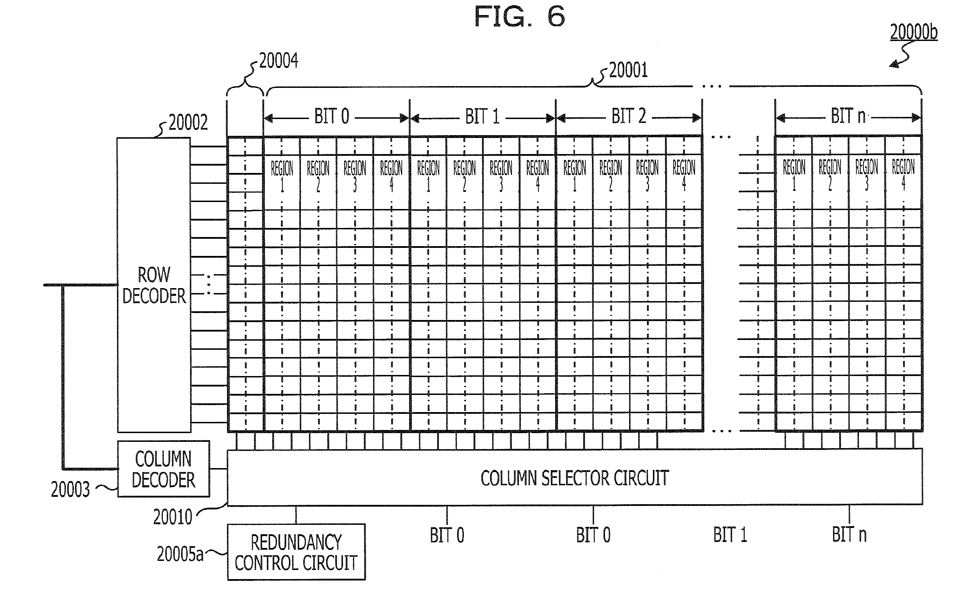

In the above-described structure, it is preferable that the redundant replacement bit 20004 constituted by memory cells for all the addresses h be provided for a defect of one bit. Therefore, a RAM 20000b illustrated in FIG. 6 has become available in recent years. In the RAM 20000b, a redundancy control circuit 20007a is capable of minutely controlling the column decoder 20003 and a column selector circuit 20010, and replacement of memory cells may be performed in units of regions of a certain number in each bit. In FIG. 6, four regions are provided for each bit.

As described above, in the RAM 20000a including the redundancy control circuit 20007 and the redundant replacement bit 20004, it is preferable to specify the bit having a defective memory cell and to cause the redundancy control circuit 20007 to switch access to the specified bit to access to the redundant replacement bit 20004.

A test for a defective memory cell is performed to detect a defective memory cell. In order to perform the test, a built-in self diagnostic circuit may be mounted in the RAM. The built-in self diagnostic circuit is called a built-in self test (BIST) circuit or a test control circuit. The BIST circuit includes a test control circuit that generates, in an LSI, an address, data, and a control signal for testing the RAM.

A data receiver (DRCV) that stores test results for individual bits may be provided to determine a bit having a defect. The DRCV stores a result of comparison between readout data output from the memory cells constituting each bit in the RAM, and an expected value supplied from the test control circuit.

Setting for the test control circuit and readout of a test result stored in the DRCV are performed by an LSI tester coupled to an LSI, via, for example, a scan chain. The test result read out by the LSI tester is used to determine whether or not the RAM has a defect. For example, when setting for the test control circuit and readout of a test result from the DRCV are performed via a scan chain, data is sequentially transferred one bit by one, which takes a long transfer time.

Along with an increasing capacity of RAMs, the number of columns per bit is increasing. An increase in the number of columns per bit causes an increase in the number of columns of memory cells of a redundant replacement bit, and accordingly the area of the redundant replacement bit increases. In many cases, a defect of a RAM is caused by a defect of one of plural columns constituting one bit. Thus, if columns of one bit are provided as columns of a replacement bit, the other normal columns are also replaced. The other normal columns are replaced although they have no defect, which degrades redundancy efficiency. There has been known a method for dividing plural columns constituting one bit into units, realizing redundancy of each of the units, and thereby dividing the columns into regions of a replacement bit, in order to increase redundancy efficiency.

In a configuration in which plural columns constituting one bit are divided into n units, after a test of the RAM in the first unit ends, a test result which is stored in a DRCV is read out to the outside of an LSI via a scan chain. Then, the setting for performing a test of the RAM in the second unit is performed for a test control circuit, and the test of the RAM is performed. After that, the test of the RAM in the third to the n-th units is performed in a similar manner. In such a case where the number of redundancy division units is n, setting and readout of a RAM test condition are repeatedly performed n times. Setting and readout of a RAM test condition are performed via a scan chain, and thus the test time is longer than a test time in a case where the columns are not divided into n units. Therefore, in the configuration in which plural columns constituting one bit are divided into units, the test time for determining a defect in all the units of the RAM increases in proportion to the number of units.

Examples of the related art are disclosed in Japanese Laid-open Patent Publications No. 07-176200, No. 2001-67890, No. 2002-42495, and No. 2001-167005.

An object of a technology disclosed here is to efficiently perform a test for determining whether or not a defective cell exists in a RAM even if the number of redundancy division units increases.

### SUMMARY

According to an aspect of the invention, a semiconductor integrated circuit includes a plurality of memory cells, a plurality of receivers, each of the plurality of receivers being provided for a corresponding one of a plurality of units set by dividing the plurality of memory cells in a unit, and each of the plurality of receivers receiving a test result of the corresponding one of the plurality of units, and a controller that reads out a plurality of test results from the plurality of receivers.

### BRIEF DESCRIPTION OF DRAWINGS

FIG. 1 is a diagram illustrating a configuration of a RAM according to the related art;

FIG. 2 is a diagram illustrating a configuration of a RAM having a row-column structure according to the related art;

FIG. 3 is a diagram illustrating a configuration of the RAM having a row-column structure according to the related art;

FIG. 4 is a diagram illustrating a configuration of a RAM having a row-column structure with a redundant replacement bit according to the related art;

FIG. 5 is a diagram illustrating a configuration of the RAM having a row-column structure with a redundant replacement bit according to the related art;

FIG. 6 is a diagram illustrating a configuration of a RAM in which memory cells are replaceable in units of regions in each bit according to the related art;

FIG. 7 is a diagram illustrating an example of a method for testing a RAM according to a first embodiment;

FIG. 8 is a block diagram illustrating a configuration of a semiconductor integrated circuit according to the first embodiment;

FIG. 9 is a block diagram illustrating a configuration of the semiconductor integrated circuit according to the first embodiment;

FIG. 10 is a diagram illustrating an example configuration of a data receiver selection signal generating circuit of the semiconductor integrated circuit according to the first embodiment;

FIG. 11 is a diagram describing a truth value table for the data receiver selection signal generating circuit of the semiconductor integrated circuit according to the first embodiment;

FIG. 12 is a diagram illustrating an example configuration of a data receiver of the semiconductor integrated circuit according to the first embodiment;

FIG. 13 is a diagram illustrating an example configuration of column selector circuits of the semiconductor integrated circuit according to the first embodiment;

FIG. 14 is a diagram illustrating an example configuration of column selector circuits of the semiconductor integrated circuit according to the first embodiment;

FIG. 15 is a diagram illustrating an example configuration of column selector circuits of the semiconductor integrated circuit according to the first embodiment;

FIG. 16 is a diagram illustrating an example configuration of column selector circuits of the semiconductor integrated circuit according to the first embodiment;

FIG. 17 is a flowchart illustrating a process of a redundancy test of the semiconductor integrated circuit according to the first embodiment;

FIG. 18 is a diagram including a pattern sequence diagram and a timing chart of a march test of the semiconductor integrated circuit according to the first embodiment;

FIG. 19 is a diagram illustrating comparison between test time for a test method according to the related art and test time for a test method according to the first embodiment;

FIG. 20 is a diagram illustrating an example configuration of a data receiver selection signal generating circuit of a semiconductor integrated circuit according to a second embodiment; and

FIG. 21 is a diagram describing a truth value table for the data receiver selection signal generating circuit of the semiconductor integrated circuit according to the second embodiment.

### DESCRIPTION OF EMBODIMENTS

Hereinafter, a technology disclosed here will be described in detail with reference to the drawings.

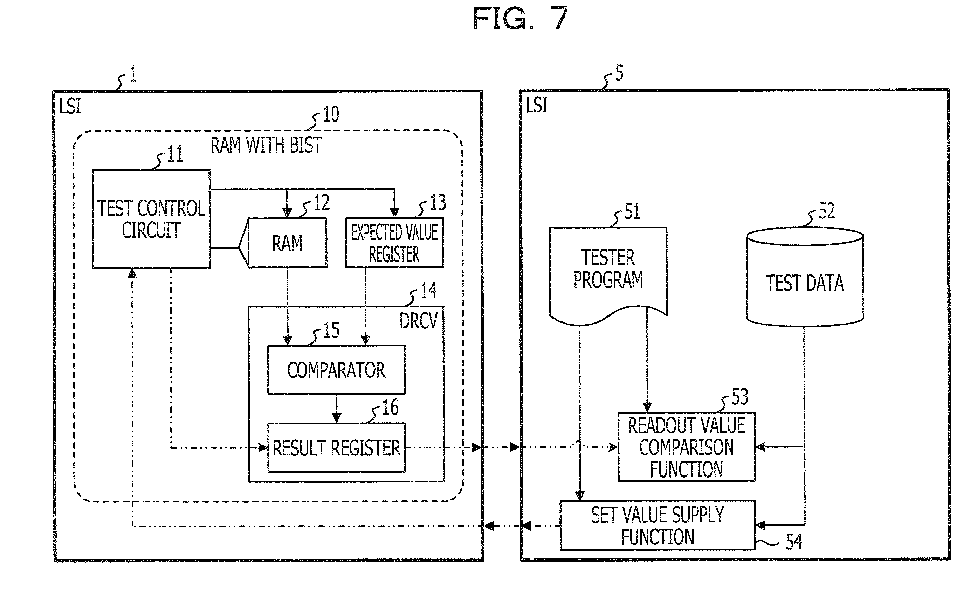

FIG. 7 illustrates an example of a method for testing a random access memory (RAM) using a built-in self test (BIST) circuit with a comparator according to a first embodiment. Usually, power, clock pulses, and so forth used for a test are supplied from a large scale integrated circuit (LSI) tester. However, the illustration of a power supply and a clock is omitted in FIG. 7. FIG. 7 illustrates an LSI 1 to be tested and an LSI tester 5.

The LSI tester 5 is a device used for testing an LSI or measuring the characteristics of the LSI. The LSI 1, which is designed to be tested and measured by using the LSI tester 5, includes an interface used by the LSI tester 5 to set a value and read out a value. In FIG. 7, the interface between the LSI tester 5 and the LSI 1 is represented by a double-dotted chain line. The LSI tester 5 sets information to be used for a test in the LSI 1 by using the interface. The LSI tester 5 reads out a test result after the test of the LSI 1 has finished.

The LSI 1 includes a RAM with BIST 10. The RAM with BIST 10 includes a test control circuit 11, a RAM 12, an expected value register 13, and a data receiver (DRCV) 14.

The RAM with BIST 10 includes, inside the LSI 1, the test control circuit 11 that generates an address, data, and a control signal for testing the RAM 12, which will be described below. The RAM with BIST 10 automatically tests the RAM 12 in accordance with minimum setting performed from the outside, and stores a test result. The RAM with BIST 10 determines whether or not the RAM 12 has a defect with reference to the test result. The RAM 12 is an example of a memory. An expected value is expected-value data which is compared with data read out from the RAM 12 at the time of BIST of the RAM 12.

The test control circuit 11 is coupled to the RAM 12, the expected value register 13, a result register 16, and the LSI tester 5. The test control circuit 11 generates, in the LSI 1, an address, data, and a control signal for testing the RAM 12. The test control circuit 11 automatically tests the RAM 12 in accordance with a set value which is supplied from a set value supply function 54 of the LSI tester 5 and which is used for a test of the RAM 12.

The RAM 12 is coupled to the test control circuit 11 and a comparator 15.

The expected value register 13 is coupled to the test control circuit 11 and the comparator 15. The expected value register 13 is used for synchronizing the timings of the data read out from the RAM 12 and an expected value.

The DRCV 14 includes the comparator 15 and the result resistor 16.

The comparator 15 is coupled to the RAM 12, the expected value register 13, and the result register 16. The comparator 15 receives data output through a test of the RAM 12, and data output from the expected value register 13. The comparator 15 compares test data of the RAM 12 with an expected value output from the expected value register 13. The comparator 15 stores a result of the comparison in the result register 16.

The result register 16 is coupled to the test control circuit 11, the comparator 15, and the LSI tester 5. The result register 16 cumulatively stores results of comparison between test data of the RAM 12 and an expected value output from the expected value register 13, the results being output from the comparator 15. For example, if a comparison result indicates "not match" even once, error information indicating "not match" is stored in the result register 16. The data about comparison results stored in the result register 16 is read out by the LSI tester 5 via a scan chain.

The LSI tester 5 includes a tester program 51, test data 52, a readout value comparison function 53, and a set value supply function 54. The LSI tester 5 includes a central processing unit (CPU) and a main storage device, which are not illustrated. The LSI tester 5 is coupled to the test control circuit 11 and the result register 16 of the LSI 1.

The tester program 51 includes a program for testing the LSI 1 and measuring characteristics of the LSI 1. The LSI tester 5 tests the LSI 1 and measures characteristics of the LSI 1 in accordance with the tester program 51 which is expanded in the main storage device in an executable manner.

The LSI tester 5 includes the test data 52, which is stored in the main storage device. The test data 52 includes test data to be input to the LSI 1 and expected value data for the data to be read out from the LSI 1. The test data 52 may be stored in an auxiliary storage device (not illustrated), such as a hard disk device or a solid state drive (SSD). The LSI tester 5 includes an interface (not illustrated) for circuits in the LSI 1, such as the test control circuit 11 and the result register 16.

The LSI tester 5 executes the tester program 51, and thereby provides the set value supply function 54 to the RAM with BIST 10 via the interface. The set value supply function 54 of the LSI tester 5 obtains a set value to be used for a test of the RAM 12 from the test data 52. The set value supply function 54 supplies the obtained set value to the test control circuit 11.

The readout value comparison function 53 sequentially compares result data read out from the LSI 1 with an expected value. Comparison results generated by the readout value comparison function 53 are output as test results of the LSI 1 to an output device (not illustrated), or are stored in a result file or the like (not illustrated).

Hereinafter, an example of a procedure of testing the LSI 1 will be described.

(1) The LSI tester 5 sets, to the test control circuit 11 via the scan chain, setting information for performing a BIST of the RAM 12 by using the test data 52 stored in the main storage device or the auxiliary storage device, in accordance with the tester program 51.

(2) The test control circuit 11 controls the BIST of the RAM 12 in accordance with the setting information set by the LSI tester 5. For example, the test control circuit 11 generates an address signal, write data, and expected value data to be supplied to the RAM 12 for performing BIST of the RAM 12.

(3) The comparator 15 compares data read out from the RAM 12 with an expected value read out from the expected value register 13. A comparison result generated by the comparator 15 is stored in the result register 16. When the comparator 15 is provided in the LSI 1, as illustrated in FIG. 7, minimum result information, for example, non-defective = 0 and defective = 1, is obtained. Thus, the amount of data read out by the LSI tester 5 from the result register 16 is small.

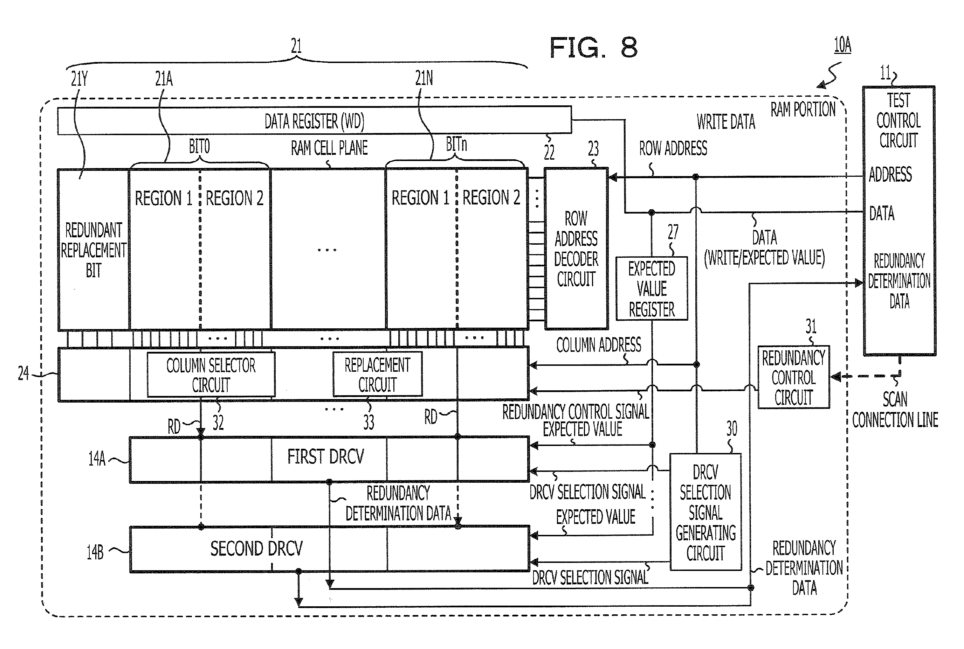

Next, the LSI 1 illustrated in FIG. 7 will be described in detail with reference to FIG. 8.

As described above regarding the related art, each bit of a RAM is divided into cells of plural regions for effective use of a redundant replacement bit.

Thus, a DRCV determines whether or not there is a defective memory cell in each region. If a single DRCV is provided, a test result is read out to the outside of an LSI via a scan chain, from the DRCV in which test results are stored in units of regions.

Every time data is output from a column selector circuit of a RAM to the DRCV, a result thereof is supplied to the LSI tester 5. However, the LSI tester 5 is coupled to a certain terminal of the LSI 1 by clipping a communication line extending from the LSI tester 5, and is thus incapable of performing highspeed communication. In order to perform detection of a defective memory cell in all the regions, readout of a test result from the DRCV via the scan chain is performed many times, the number of which corresponds to the number of regions. Accordingly, it takes a long time to perform a test.

In view of this point, according to this embodiment, plural DRCV are provided, the number of which corresponds to the number of regions. When scanning of all the regions of a bit is completed, information indicating the presence or absence of a defective memory cell obtained by the individual DRCVs is collectively transmitted to the LSI tester 5. With this configuration, communication efficiency is increased and time for testing the LSI 1 is shortened, compared to the case of repeatedly performing communication.

FIG. 8 is a block diagram illustrating a configuration of a semiconductor integrated circuit (LSI 1) according to the first embodiment. With reference to FIG. 8, redundancy determination data output from a first DRCV 14A and a second DRCV 14B will be described. In FIG. 8, the same elements as those described above with reference to FIG. 7 are denoted by the same reference numerals, and the description thereof is omitted.

As illustrated in FIG. 8, a RAM cell plane (bit 0) 21A has a structure in which a redundant unit of one bit is divided into two regions in the column direction. A RAM cell plane (bit n) 21N has a structure in which a redundant unit of one bit is divided into two regions in the column direction.

When receiving a redundancy control signal from a redundancy control circuit 31, a replacement circuit 33 replaces any of the RAM cell plane (bit 0) 21A to the RAM cell plane (bit n) 21N having a defective memory cell with a redundant replacement bit 21Y, in accordance with a test result of a RAM 21.

If the replacement circuit 33 replaces the RAM cell plane (bit 0) 21A with the redundant replacement bit 21Y, a column address decoder circuit 24 specifies a column address in the column direction in the redundant replacement bit 21Y. If a row address in the redundant replacement bit 21Y is activated by a row address decoder circuit 23, the column address decoder circuit 24 activates a "column address select" signal corresponding to the redundant replacement bit 21Y by using a column selector circuit 32, and uses the redundant replacement bit 21Y instead of any of the RAM cell plane (bit 0) 21A to the RAM cell plane (bit n) 21N having a defective memory cell.

The first DRCV 14A and the second DRCV 14B are coupled to the column address decoder circuit 24 and the test control circuit 11. When receiving a DRCV selection signal from a DRCV selection signal generating circuit 30, the first DRCV 14A compares an expected value corresponding to the RAM cell plane (bit 0) 21A output from the test control circuit 11 with data output from the RAM cell plane (bit 0) 21A. The first DRCV 14A outputs a comparison result, which is redundancy determination data, to the test control circuit 11. The test control circuit 11 receives the redundancy determination data output from the first DRCV 14A.

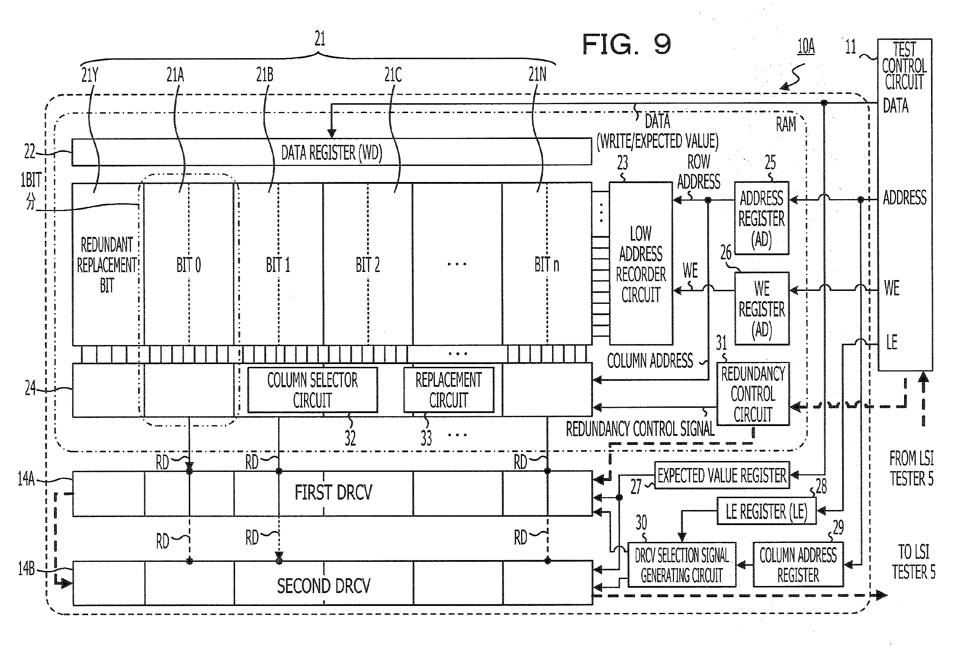

FIG. 9 is a more detailed block diagram illustrating a configuration of the semiconductor integrated circuit in which a region of each bit illustrated in FIG. 8 is divided into plural regions (in this embodiment, two regions), and DRCVs the number of which corresponds to the number of regions are provided. In FIG. 9, the same elements as those described above with reference to FIGs. 7 and 8 are denoted by the same reference numerals, and the description thereof is omitted.

A RAM with BIST 10A includes the test control circuit 11, the RAM 21, the first DRCV 14A, the second DRCV 14B, a data register 22, the row address decoder circuit 23, the column address decoder circuit 24, an address register 25, a write enable (WE) register 26, an expected value register 27, a latch enable (LE) register 28, a column address register 29, the DRCV selection signal generating circuit 30, and the redundancy control circuit 31.

The RAM 21 is coupled to the data register 22, the row address decoder circuit 23, the column address decoder circuit 24, and the expected value register 27. The RAM 21 includes a RAM cell plane (bit 0) 21A, a RAM cell plane (bit 1) 21B, a RAM cell plane (bit 2) 21C, ···, a RAM cell plane (bit n) 21N, and a redundant replacement bit 21Y. The RAM 21 includes memory cells (not illustrated) arranged in a matrix, in the row direction and the column direction. In the RAM 21, word lines (not illustrated) are arranged in the row direction, and bit lines (not illustrated) are arranged in the column direction. Each of the memory cells of the RAM 21 is specified by a unique address including a row address in the row direction and a column address in the column direction. The memory cells of the RAM 21 are coupled to the word lines and bit lines. The memory cells of the RAM 21 store data supplied from the test control circuit 11 when the word lines and bit lines are activated. Also, the memory cells of the RAM 21 output the data stored therein to the first DRCV 14A or second DRCV 14B.

The RAM 21 includes the RAM cell plane (bit 0) 21A, the RAM cell plane (bit 1) 21B, the RAM cell plane (bit 2) 21C, ···, and the RAM cell plane (bit n) 21N, each corresponding to a bit of data. Furthermore, each of these RAM cell planes includes two regions.

The redundant replacement bit 21Y is provided to be used instead of any of the RAM cell plane (bit 0) 21A, the RAM cell plane (bit 1) 21B, the RAM cell plane (bit 2) 21C, ···, and the RAM cell plane (bit n) 21N which has a defective memory cell when a test result of the RAM 21 indicates that the RAM cell plane has a defective memory cell.

The test control circuit 11 is coupled to the data register 22, the address register 25, the WE register 26, the redundancy control circuit 31, the expected value register 27, the LE register 28, the column address register 29, and the set value supply function 54 of the LSI tester 5 illustrated in FIG. 7. The test control circuit 11 outputs an address signal of the RAM 21 to the address register 25. The address signal of the RAM 21 is temporarily stored in the address register 25. The test control circuit 11 outputs an address signal of the RAM 21 to the column address register 29. The address signal of the RAM 21 is temporarily stored in the column address register 29.

The test control circuit 11 outputs a WE signal to the WE register 26. The WE signal is a switch signal for writing data on or reading data from the RAM 21. When the test control circuit 11 outputs a WE signal "1" to the WE register 26, writing data on the RAM 21 is permitted. The test control circuit 11 writes data on the RAM 21 at the address specified by an address signal of the RAM 21. When the test control circuit 11 outputs a WE signal "0" to the WE register 26, reading data from the RAM 21 is permitted. The test control circuit 11 outputs, as a readout data signal from the RAM 21, the content of data stored in the RAM 21 at the address specified by the address signal of the RAM 21. The WE signal is temporarily stored in the WE register 26.

The test control circuit 11 outputs a write data signal to the data register 22. The write data signal includes a write data signal of the RAM 21 and an expected value signal used for testing the RAM 21. The write data signal is temporarily stored in the data register 22.

The test control circuit 11 outputs an LE signal to the LE register 28. The LE signal is a control signal for the first DRCV 14A and the second DRCV 14B, which will be described below. The LE signal is temporarily stored in the LE register 28. When the test control circuit 11 outputs an LE signal "1" to the LE register 28, the first DRCV 14A and the second DRCV 14B compare readout data output from the RAM 21 with an expected value output from the expected value register 27, and capture a comparison result. When the test control circuit 11 outputs an LE signal "0" to the LE register 28, the first DRCV 14A and the second DRCV 14B do not capture a comparison result.

During a test of the RAM 21, the test control circuit 11 may read out data from the RAM 21, read out data by using the first DRCV 14A and the second DRCV 14B, compare the readout data output from the RAM 21 with an expected value, and regard an inverted WE signal as an LE signal. In this method, however, comparison is performed by the first DRCV 14A and the second DRCV 14B every time data is read out from the RAM 21. If an address of the RAM 21 at which data has not been written is read during a test of the RAM 21, the value of a data signal is indefinite and an expected value is not set, and thus it may be undesirable to compare readout data output from the RAM 21. Therefore, in the first embodiment, an LE signal is used for controlling whether or not readout data output from the RAM 21 is to be compared by each of the first DRCV 14A and the second DRCV 14B independently, instead of inverting a WE signal.

The test control circuit 11 receives a scan chain signal from the set value supply function 54 of the LSI tester 5 illustrated in FIG. 7. A connection line of the scan chain is represented by a broken line in FIG. 8. The scan chain signal is used for performing setting, when a test result of the RAM 21 indicates that any of the RAM cell plane (bit 0) 21A, the RAM cell plane (bit 1) 21B, the RAM cell plane (bit 2) 21C, ···, and the RAM cell plane (bit n) 21N has a defective memory cell, to replace the RAM cell plane having a defective cell with the redundant replacement bit 21Y. The test control circuit 11 outputs the received scan chain signal to the redundancy control circuit 31.

The data register 22 is coupled to the test control circuit 11, the RAM 21, and the expected value register 27. The data register 22 temporarily stores data output from the test control circuit 11. The data register 22 outputs data to be used for testing the RAM 21 to the RAM 21. The data register 22 outputs an expected value to be used for testing the RAM 21 to the expected value register 27.

The expected value register 27 is coupled to the data register 22, the first DRCV 14A, and the second DRCV 14B. The expected value register 27 temporarily stores an expected value corresponding to the RAM cell plane (bit 0) 21A output from the data register 22, and an expected value corresponding to the RAM cell plane (bit 1) 21B. The expected value register 27 outputs the temporarily-stored expected value corresponding to the RAM cell plane (bit 0) 21A to the first DRCV 14A. The expected value register 27 outputs the temporarily-stored expected value corresponding to the RAM cell plane (bit 1) 21B to the second DRCV 14B.

The LE register 28 is coupled to the test control circuit 11. The test control circuit 11 outputs an LE signal "1" indicating that an expected value has been output, or an LE signal "0" indicating that an expected value has not been output. The expected value register 27 stores the value.

The column address register 29 is coupled to the test control circuit 11 and the DRCV selection signal generating circuit 30. The column address register 29 temporarily stores a column address signal of the RAM 21 output from the test control circuit 11. The column address register 29 outputs the temporarily-stored column address signal to the DRCV selection signal generating circuit 30.

The DRCV selection signal generating circuit 30 is coupled to the LE register 28, the column address register 29, the first DRCV 14A, and the second DRCV 14B. The DRCV selection signal generating circuit 30 outputs, in accordance with a column address signal received from the column address register 29 and an LE signal received from the LE register 28, a selection signal to a corresponding one of the first DRCV 14A and the second DRCV 14B.

The address register 25 is coupled to the test control circuit 11, the row address decoder circuit 23, and the column address decoder circuit 24. The address register 25 temporarily stores address information about the RAM 21 output from the test control circuit 11. The address register 25 outputs row address information about the RAM 21 to the row address decoder circuit 23. The address register 25 outputs column address information about the RAM 21 to the column address decoder circuit 24.

The WE register 26 is coupled to the test control circuit 11 and the row address decoder circuit 23. The WE register 26 temporarily stores a WE signal of the RAM 21 output from the test control circuit 11. The WE register 26 outputs the WE signal of the RAM 21 to the row address decoder circuit 23.

The row address decoder circuit 23 is coupled to the address register 25, the WE register 26, and the RAM 21. The row address decoder circuit 23 decodes a row address signal in accordance with a row address signal received from the address register 25 and a WE signal received from the WE register 26, and activates a word line (not illustrated) indicated by a decoded value. When the word line is activated by the received WE signal, the row address decoder circuit 23 stops the decoding operation. The row address decoder circuit 23 specifies a row address in the row direction on the RAM cell plane (bit 0) 21A, the RAM cell plane (bit 1) 21B, the RAM cell plane (bit 2) 21C, ···, and the RAM cell plane (bit n) 21N.

The column address decoder circuit 24 includes the column selector circuit 32 and the replacement circuit 33. The column address decoder circuit 24 is coupled to the RAM cell plane (bit 0) 21A, the RAM cell plane (bit 1) 21B, the RAM cell plane (bit 2) 21C, ···, the RAM cell plane (bit n) 21N, the address register 25, the redundancy control circuit 31, the first DRCV 14A, and the second DRCV 14B.

The column address decoder circuit 24 specifies a column address in the column direction on the RAM cell plane (bit 0) 21A, the RAM cell plane (bit 1) 21B, the RAM cell plane (bit 2) 21C, ···, and the RAM cell plane (bit n) 21N in accordance with a column address signal of the RAM 21 output from the address register 25. When a row address is activated by the above-described row address decoder circuit 23, the column address decoder circuit 24 retrieves the data written in advance in the column address of the specified RAM cell plane (bit 0) 21A, RAM cell plane (bit 1) 21B, RAM cell plane (bit 2) 21C, ···, and RAM cell plane (bit n) 21N.

The column address decoder circuit 24 outputs the data retrieved from the RAM cell plane (bit 0) 21A to the first DRCV 14A. The column address decoder circuit 24 outputs the data retrieved from the RAM cell plane (bit 1) 21B to the second DRCV 14B.

The column selector circuit 32 decodes a column address signal received from the address register 25, and activates a "column address select" signal indicated by a decoded value. The "column address select" signal is used for selecting a bit line (not illustrated) of the RAM 21.

When receiving a redundancy control signal from the redundancy control circuit 31, the replacement circuit 33 replaces, in accordance with a test result of the RAM 21, any of the RAM cell plane (bit 0) 21A, the RAM cell plane (bit 1) 21B, the RAM cell plane (bit 2) 21C, ···, and the RAM cell plane (bit n) 21N having a defective cell with the redundant replacement bit 21Y.

The first DRCV 14A and the second DRCV 14B are coupled to the column address decoder circuit 24, the expected value register 27, the DRCV selection signal generating circuit 30, and the redundancy control circuit 31. Each of the first DRCV 14A and the second DRCV 14B synchronizes with an LE signal, responds to a DRCV selection signal supplied from the DRCV selection signal generating circuit 30, compares expected values corresponding to regions of the RAM cell planes 21A to 21N output from the expected value register 27 with the data actually output from the RAM 21, and stores the result.

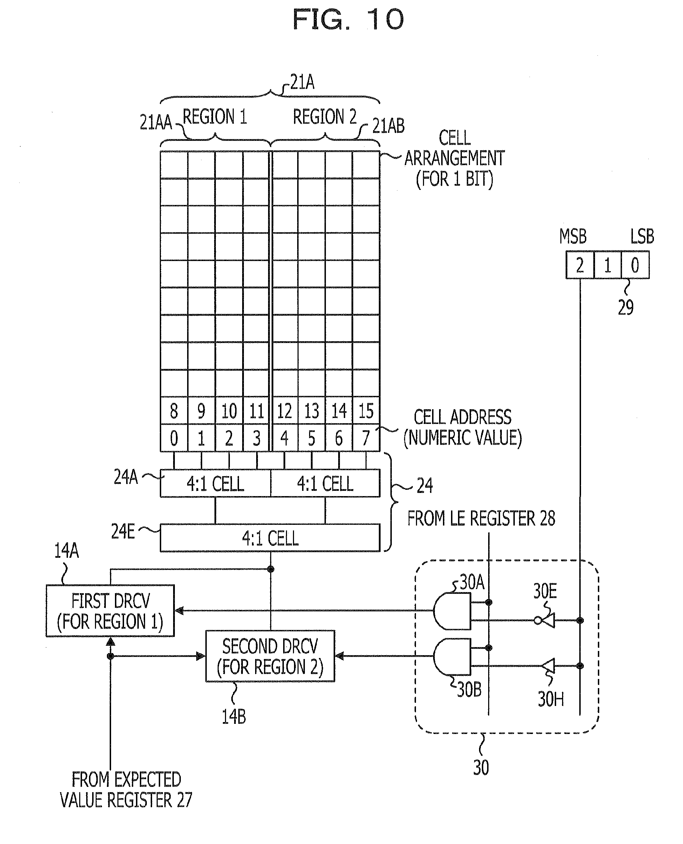

FIG. 10 is a diagram illustrating an example configuration of the DRCV selection signal generating circuit 30 of the semiconductor integrated circuit according to the first embodiment. In FIG. 10, the same elements as those described above with reference to FIGs. 7 to 9 are denoted by the same reference numerals, and the description thereof is omitted.

As illustrated in FIG. 10, the RAM with BIST 10A according to this embodiment has a structure in which each bit of the RAM 21 is divided into two regions in the column direction. For example, the RAM cell plane 21A of the zero-th bit of the RAM 21 is divided into two regions 21AA and 21AB. The numbers assigned to the memory cells of the RAM cell plane 21A represent cell addresses. As illustrated in FIG. 10, the RAM cell plane 21A includes eight cells arranged in the column direction, and the cell addresses are assigned along the arrangement. In this embodiment, each RAM cell plane is divided into two regions. Thus, sets of four addresses are alternately assigned to the regions 21AA and 21AB. For example, the region 21AA includes the memory cells to which cell addresses 0, 1, 2, 3, 8, 9, 10, ··· are assigned.

The column address decoder circuit 24 includes column address decoder circuits 24A and 24B coupled to the respective regions, and a column address decoder circuit 24E coupled to the output side of the column address decoder circuits 24A and 24B.

Each of the column address decoder circuits 24A and 24B reads out the data stored in the memory cells in a corresponding one of the regions 21AA and 21AB, and outputs the data to the column address decoder circuit 24E.

The column address decoder circuit 24E is coupled to the column address decoder circuit 24A, the column address decoder circuit 24B, the first DRCV 14A, and the second DRCV 14B. The column address decoder circuit 24E outputs data read out from the column address decoder circuit 24A and the column address decoder circuit 24B to the first DRCV 14A and the second DRCV 14B.

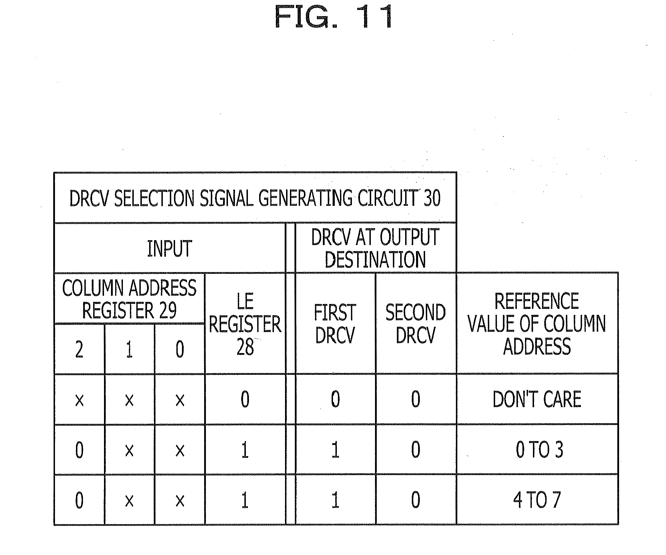

The column address register 29 stores column addresses in the RAM 21, in the form of a three-bit value (zero-th to second bits) using a binary number. In FIG. 10, the most significant bit is represented by MSB, and the least significant bit is represented by LSB. The correspondence between the MSB and LSB in the column address register 29 and the cell addresses of the RAM 21 will be described below with reference to FIG. 11.

The DRCV selection signal generating circuit 30 includes circuits 30A to 30H, including an AND circuit.

As illustrated in FIG. 11, when the value of the LE register 28 is one, the DRCV selection signal generating circuit 30 outputs a selection signal to the first DRCV 14A when the value of MSB in the column register 29 is zero, and outputs a selection signal to the second DRCV 14B when the value of MSB in the column register 29 is one.

When the value of the LE register 28 is zero, no test data is output, and thus output is not performed from any of the first DRCV 14A and the second DRCV 14B.

The first DRCV 14A or the second DRCV 14B compares a value supplied from the expected value register 27 with a value supplied from the column address decoder circuit 24E in accordance with the selection signal, and stores a comparison result.

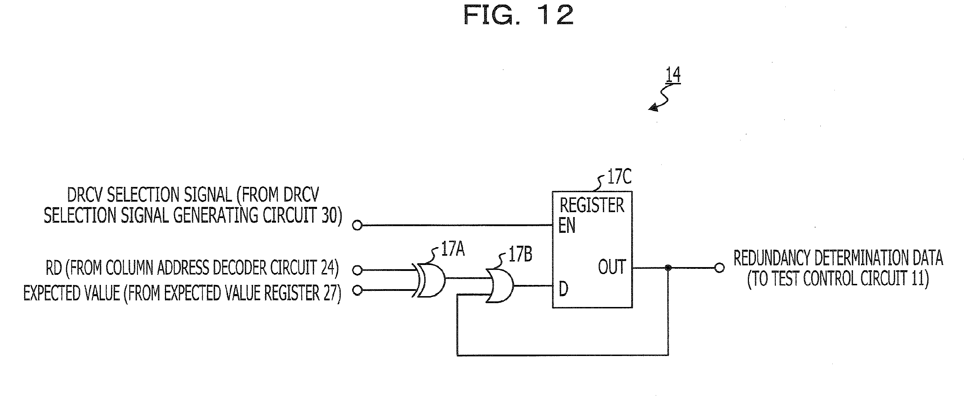

FIG. 12 is a diagram illustrating an example configuration of the first DRCV 14A and the second DRCV 14B of the semiconductor integrated circuit. The first DRCV 14A and the second DRCV 14B have the same configuration, and are thus collectively illustrated as a DRCV 14 in FIG. 12. In FIG. 12, the same elements as those described above with reference to FIGs. 7 to 11 are denoted by the same reference numerals, and the description thereof is omitted.

As illustrated in FIG. 12, the DRCV 14 includes an EX-OR circuit 17A, an OR circuit 17B, and a register 17C.

The EX-OR circuit 17A is coupled to the column address decoder circuit 24, the expected value register 27, and the OR circuit 17B. The EX-OR circuit 17A outputs, to the OR circuit 17B, a determination signal indicating whether or not readout data received from the column address decoder circuit 24 matches an expected value received from the expected value register 27. If the readout data received from the column address decoder circuit 24 matches the expected value received from the expected value register 27, the EX-OR circuit 17A outputs a determination signal "0" to the OR circuit 17B. If the readout data received from the column address decoder circuit 24 does not match the expected value received from the expected value register 27, the EX-OR circuit 17A outputs a determination signal "1" to the OR circuit 17B.

The OR circuit 17B is coupled to the EX-OR circuit 17A, an output terminal (OUT) of the register 17C, and a data terminal (D) of the register 17C. The OR circuit 17B outputs, to the data terminal of the register 17C, the logical OR of a determination signal received from the EX-OR circuit 17A and an output signal received from the output terminal of the register 17C.

An enable terminal (EN) of the register 17C is coupled to the DRCV selection signal generating circuit 30. The data terminal of the register 17C is coupled to the OR circuit 17B. The output terminal of the register 17C is coupled to the test control circuit 11 and the OR circuit 17B.

When an EN signal "1" is input from the DRCV selection signal generating circuit 30, the register 17C becomes capable of writing data therein. The register 17C writes data received from the OR circuit 17B. The register 17C outputs the written data to the test control circuit 11 and the OR circuit 17B from the output terminal. When an EN signal "0" is input from the DRCV selection signal generating circuit 30, the register 17C becomes incapable of writing data therein, and is initialized.

The operation of the DRCV 14 during a test of the RAM 21 will be described. First, an initial value "0" is set for the register 17C, and then a test of the RAM 21 is started. In the EX-OR circuit 17A, if readout data received from the column address decoder circuit 24 matches an expected value received from the expected value register 27, a determination signal "0" is output to the OR circuit 17B. Since the initial value "0" is set for the register 17C, the OR circuit 17B receives the determination signal "0" and the initial value "0" of the register 17C. Thus, the logical OR output from the OR circuit 17B is "0", and data written in the register 17C is "0".

On the other hand, in the EX-OR circuit 17A, if readout data received from the column address decoder circuit 24 does not match an expected value received from the expected value register 27, a determination signal "1" is output to the OR circuit 17B. In this case, the logical OR output from the OR circuit 17B is "1" regardless of the signal output from the output terminal of the register 17C. Thus, data written in the register 17C is "1".

Once the data written in the register 17C becomes "1", the logical OR output from the OR circuit 17B and the signal output from the output terminal of the register 17C are "1" regardless of the value output from the EX-OR circuit 17A, and the data written in the register 17C is continuously "1". That is, if readout data received from the column address decoder circuit 24 does not match an expected value received from the expected value register 27 even once during a test of the RAM 21, the data written in the register 17C is continuously "1". After the test of the RAM 21, the data written in the register 17C is read out. If the data is "1", it means that one or more mismatches occurred and a defect was found in the RAM 21 during the test of the RAM 21.

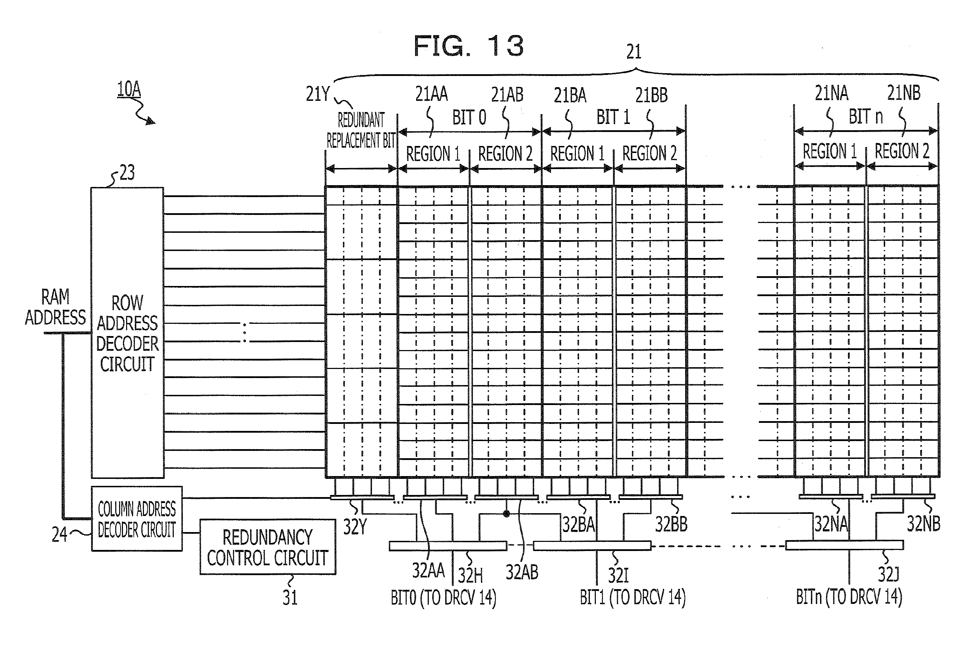

FIG. 13 is a diagram illustrating an example configuration of column selector circuits of the semiconductor integrated circuit according to the first embodiment. In FIG. 13, the same elements as those described above with reference to FIGs. 7 to 9 are denoted by the same reference numerals, and the description thereof is omitted.

As illustrated in FIG. 13, the RAM with BIST 10A according to the first embodiment has a structure in which a redundant unit of one bit of the RAM 21 is divided into two regions in the column direction. That is, the RAM 21 includes regions 21AA and 21AB of the RAM cell plane for bit 0, regions 21BA and 21BB of the RAM cell plane for bit 1, ···, and regions 21NA and 21NB of the RAM cell plane for bit n.

A column selector circuit 32Y is coupled to the redundant replacement bit 21Y, a column selector circuit 32H, and the column address decoder circuit 24. When any of the regions 21AA, 21AB, 21BA, 21BB, ···, 21NA, and 21NB has a defective memory cell, the column selector circuit 32Y uses the redundant replacement bit 21Y instead of the RAM cell plane having the defective memory cell, in response to a redundancy control signal received from the redundancy control circuit 31 via the column selector circuit 32H. The column selector circuit 32Y activates a "column address select" signal corresponding to the redundant replacement bit 21Y in response to an instruction provided from the column address decoder circuit 24.

A column selector circuit 32AA is coupled to the region 21AA, the column selector circuit 32H, and the column address decoder circuit 24. The column selector circuit 32AA activates a "column address select" signal corresponding to the region 21AA in response to an instruction provided from the column address decoder circuit 24.

A column selector circuit 32AB is coupled to the region 21AB, the column selector circuit 32H, and the column address decoder circuit 24. The column selector circuit 32AB activates a "column address select" signal corresponding to the region 21AB in response to an instruction provided from the column address decoder circuit 24.

A column selector circuit 32BA is coupled to the region 21BA, a column selector circuit 32I, and the column address decoder circuit 24. The column selector circuit 32BA activates a "column address select" signal corresponding to the region 21BA in response to an instruction provided from the column address decoder circuit 24.

A column selector circuit 32BB is coupled to the region 21BB, the column selector circuit 32I, and the column address decoder circuit 24. The column selector circuit 32BB activates a "column address select" signal corresponding to the region 21BB in response to an instruction provided from the column address decoder circuit 24.

A column selector circuit 32NA is coupled to the region 21NA, a column selector circuit 32J, and the column address decoder circuit 24. The column selector circuit 32NA activates a "column address select" signal corresponding to the region 21NA in response to an instruction provided from the column address decoder circuit 24.

A column selector circuit 32NB is coupled to the region 21NB, the column selector circuit 32J, and the column address decoder circuit 24. The column selector circuit 32NB activates a "column address select" signal corresponding to the region 21NB in response to an instruction provided from the column address decoder circuit 24.

The column selector circuit 32H is coupled to the column selector circuit 32Y, the column selector circuit 32AA, the column selector circuit 32AB, the redundancy control circuit 31, and the DRCV 14 (not illustrated) corresponding to the zero-th bit of the RAM 21. The column selector circuit 32H selects two column selector circuits from among the column selector circuit 32Y, the column selector circuit 32AA, and the column selector circuit 32AB. The column selector circuit 32H outputs the data corresponding to the zero-th bit of the RAM 21 to the DRCV 14 (not illustrated) corresponding to the zero-th bit of the RAM 21.

If a defective memory cell is included in the RAM cell plane of any of the region 21AA, region 21AB, region 21BA, region 21BB, ···, region 21NA, and region NB, the column selector circuit 32H outputs a signal for selecting any one of the column selector circuit 32AA and the column selector circuit 32AB coupled to a normal RAM cell plane including no defective memory cell, and the column selector 32Y, in response to an instruction provided from the redundancy control circuit 31. The column selector circuit 32Y activates a "column address select" signal corresponding to the redundant replacement bit 21Y in response to the signal output from the column selector circuit 32H and an instruction provided from the column address decoder circuit 24 corresponding to the redundant replacement bit 21Y.

The column selector circuit 32I is coupled to the column selector circuit 32AB, the column selector circuit 32BA, the column selector circuit 32BB, the redundancy control circuit 31, and the DRCV 14 (not illustrated) corresponding to the first bit of the RAM 21. The column selector circuit 32I selects two column selector circuits from among the column selector circuit 32AB, the column selector circuit 32BA, and the column selector circuit 32BB. The column selector circuit 32I outputs the data corresponding to the first bit of the RAM 21 to the DRCV 14 (not illustrated) corresponding to the first bit of the RAM 21.

If a defective memory cell is included in the RAM cell plane of any of the region 21AB, region 21BA, and region 21BB, the column selector circuit 32I outputs a signal for selecting two column selector circuits coupled to a normal RAM cell plane including no defective memory cell from among the column selector circuit 32AB, the column selector circuit 32BA, and the column selector circuit 32BB, in response to an instruction provided from the redundancy control circuit 31. A RAM cell plane including a defective memory cell is replaced with the redundant replacement bit 21Y in response to an instruction provided from the redundancy control circuit 31.

The column selector circuit 32J is coupled to the column selector circuit 32NA, the column selector circuit 32NB, a column selector circuit (not illustrated), the redundancy control circuit 31, and the DRCV 14 (not illustrated) corresponding to the n-th bit of the RAM 21. The column selector circuit 32J selects two column selector circuits from among the column selector circuit 32NA, the column selector circuit 32NB, and the not illustrated column selector circuit. The column selector circuit 32J outputs the data corresponding to the n-th bit of the RAM 21 to the DRCV 14 (not illustrated) corresponding to the n-th bit of the RAM 21.

If a defective memory cell is included in any of the region 21NA and the region 21NB, the column selector circuit 32J outputs a signal for selecting two column selector circuits coupled to a normal RAM cell plane including no defective memory cell from among the column selector circuit 32NA, the column selector circuit 32NB, and the not illustrated column selector circuit, in response to an instruction provided from the redundancy control circuit 31. A RAM cell plane including a defective memory cell is replaced with the redundant replacement bit 21Y in response to an instruction provided from the redundancy control circuit 31.

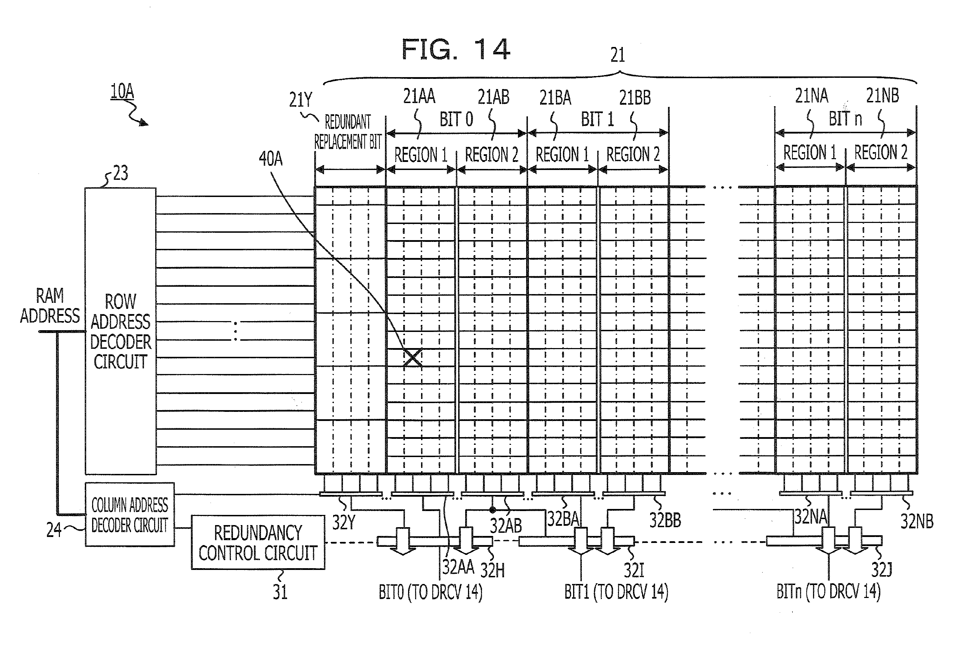

FIG. 14 is a diagram illustrating an example configuration of column selector circuits of the semiconductor integrated circuit according to the first embodiment. FIG. 14 illustrates an example configuration in which a defective memory cell 40A is included in the region 21AA. In FIG. 14, the same elements as those described above with reference to FIGs. 7 to 13 are denoted by the same reference numerals, and the description thereof is omitted.

As illustrated in FIG. 14, the redundancy control circuit 31 outputs a signal for selecting the column selector circuit 32Y and the column selector circuit 32AB to the column selector circuit 32H. The redundancy control circuit 31 outputs a signal for selecting the column selector circuit 32BA and the column selector circuit 32BB to the column selector circuit 32I. The redundancy control circuit 31 outputs a signal for selecting the column selector circuit 32NA and the column selector circuit 32NB to the column selector circuit 32J. The redundant replacement bit 21Y is used instead of the region 21AA including the defective memory cell 40A. Thus, the region 21AA including the defective memory cell 40A may be separated.

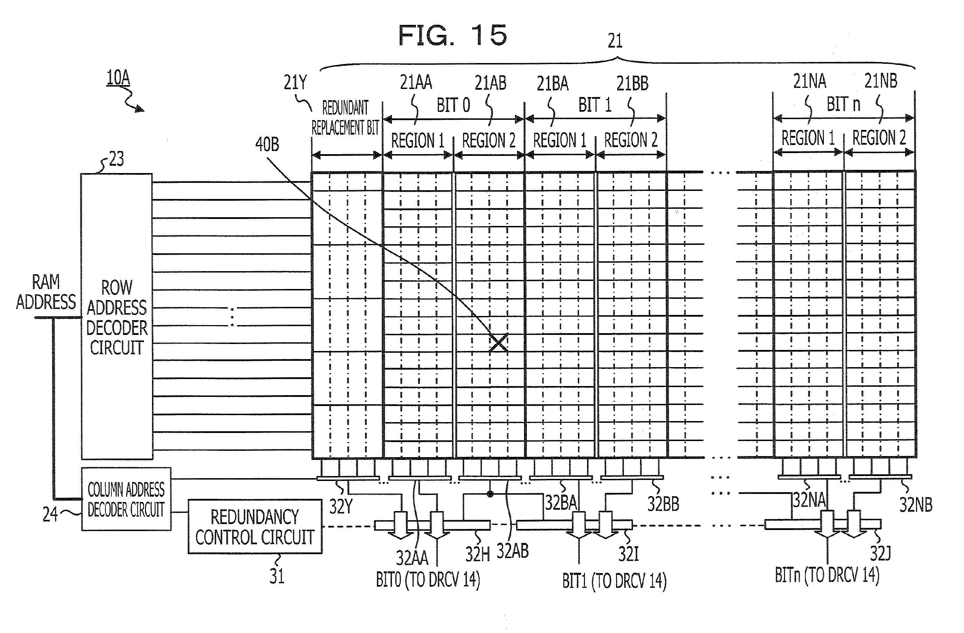

FIG. 15 is a diagram illustrating an example configuration of column selector circuits of the semiconductor integrated circuit according to the first embodiment. FIG. 15 illustrates an example configuration in which a defective memory cell 40B is included in the region 21AB. In FIG. 15, the same elements as those described above with reference to FIGs. 7 to 14 are denoted by the same reference numerals, and the description thereof is omitted.

As illustrated in FIG. 15, the redundancy control circuit 31 outputs a signal for selecting the column selector circuit 32Y and the column selector circuit 32AA to the column selector circuit 32H. The redundancy control circuit 31 outputs a signal for selecting the column selector circuit 32BA and the column selector circuit 32BB to the column selector circuit 32I. The redundancy control circuit 31 outputs a signal for selecting the column selector circuit 32NA and the column selector circuit 32NB to the column selector circuit 32J. The redundant replacement bit 21Y is used instead of the region 21AB including the defective memory cell 40B. Thus, the region 21AB including the defective memory cell 40B may be separated.

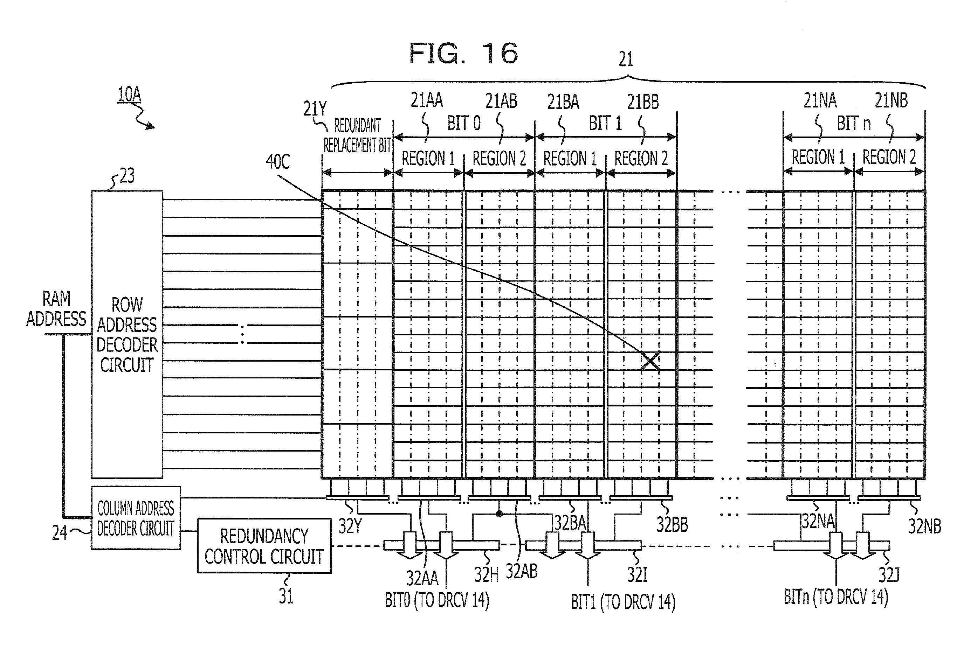

FIG. 16 is a diagram illustrating an example configuration of column selector circuits of the semiconductor integrated circuit according to the first embodiment. FIG. 16 illustrates an example configuration in which a defective memory cell 40C is included in the region 21BB. In FIG. 16, the same elements as those described above with reference to FIGs. 7 to 15 are denoted by the same reference numerals, and the description thereof is omitted.

As illustrated in FIG. 16, the redundancy control circuit 31 outputs a signal for selecting the column selector circuit 32Y and the column selector circuit 32AA to the column selector circuit 32H. The redundancy control circuit 31 outputs a signal for selecting the column selector circuit 32AB and the column selector circuit 32BA to the column selector circuit 32I. The redundancy control circuit 31 outputs a signal for selecting the column selector circuit 32NA and the column selector circuit 32NB to the column selector circuit 32J. The redundant replacement bit 21Y is used instead of the region 21BB including the defective memory cell 40C. Thus, the region 21BB including the defective memory cell 40C may be separated.

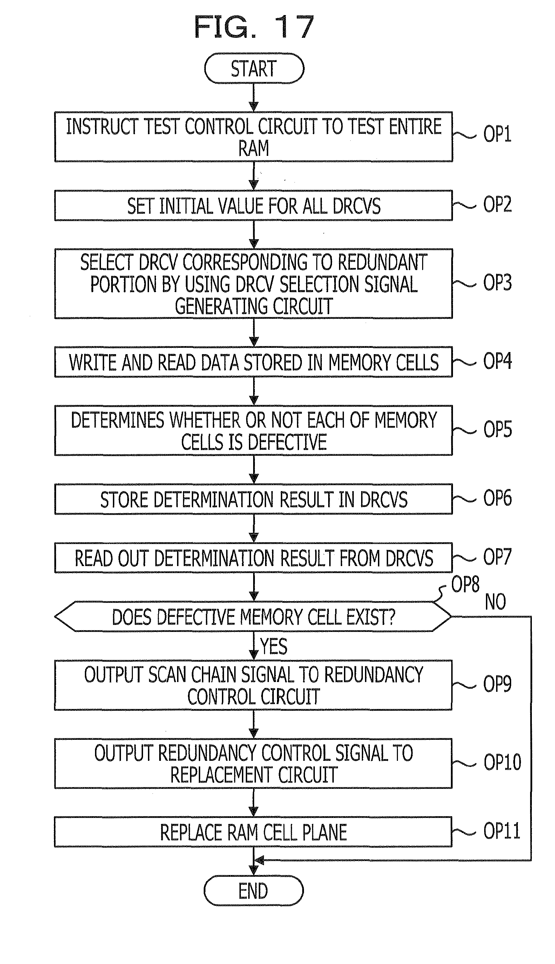

FIG. 17 is a flowchart illustrating a process of a redundancy test for the semiconductor integrated circuit according to the first embodiment.

In OP1, the LSI tester 5 illustrated in FIG. 7 instructs the test control circuit 11 illustrated in FIG. 8 to test the entire RAM 21.

In OP2, the LSI tester 5 sets an initial value for all the DRCVs 14 including the first DRCV 14A and the second DRCV 14B illustrated in FIG. 8.

In OP3, when testing the entire RAM 21, the test control circuit 11 selects any one of all the DRCVs 14 including the first DRCV 14A and the second DRCV 14B corresponding to a redundancy division portion, by using the DRCV selection signal generating circuit 30 illustrated in FIG. 8.

In OP4, the test control circuit 11 performs write and read of data stored in the memory cells of the entire RAM 21 by using all the DRCVs 14 including the first DRCV 14A and the second DRCV 14B.

In OP5, the test control circuit 11 determines whether or not each of the memory cells of the entire RAM 21 is defective by using all the DRCVs 14 including the first DRCV 14A and the second DRCV 14B.

In OP6, the test control circuit 11 stores a determination result about the memory cells of the entire RAM 21 in all the DRCVs 14 including the first DRCV 14A and the second DRCV 14B.

In OP7, the test control circuit 11 reads out the determination result about the memory cells of the entire RAM 21 from all the DRCVs 14 including the first DRCV 14A and the second DRCV 14B.

In OP8, the test control circuit 11 determines whether or not a defective memory cell exists in the RAM 21. If a detective memory cell exists in the RAM 21 (YES in OP8), the test control circuit 11 outputs a scan chain signal to the redundancy control circuit 31 in accordance with the determination result about the memory cells of the entire RAM 21 in OP9. If a defective memory cell does not exist in the RAM 21 (NO in OP8), the test control circuit 11 ends the process of the redundancy test.

In OP10, the redundancy control circuit 31 outputs a redundancy control signal to the replacement circuit 33 of the column address decoder circuit 24.

When receiving the redundancy control signal from the redundancy control circuit 31, in OP 11, the replacement circuit 33 replaces the RAM cell plane having a defective memory cell among the RAM cell plane (bit 0) 21A to the RAM cell plane (bit n) 21N with the redundant replacement bit 21Y, in accordance with the test result of the RAM 21.

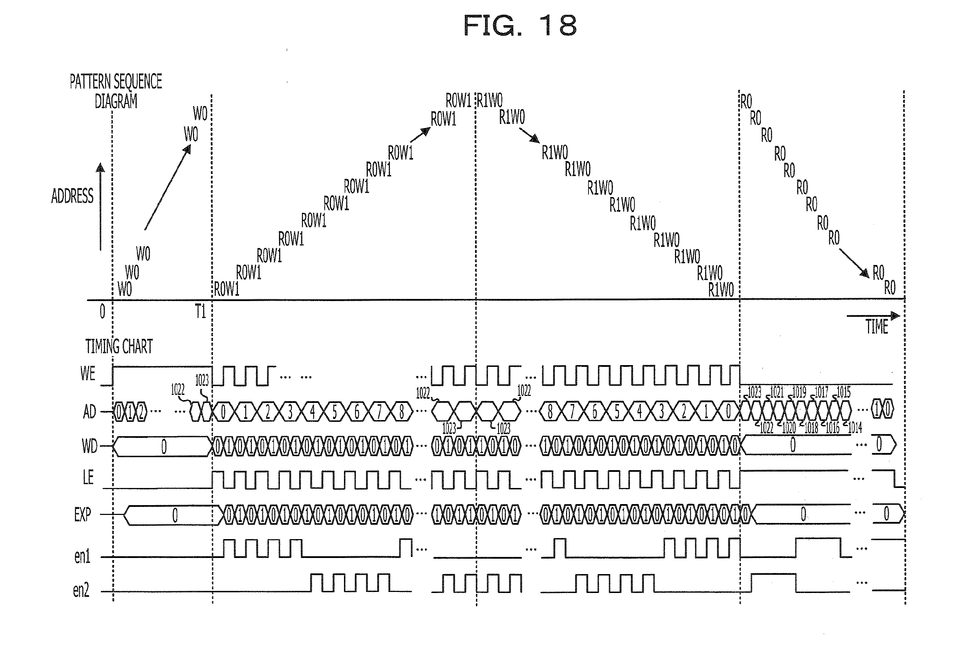

FIG. 18 is a diagram including a pattern sequence diagram and a timing chart of a match test of the semiconductor integrated circuit according to the first embodiment. The test control circuit 11 illustrated in FIG. 8 tests the memory cells of the RAM 21 one by one in order of addresses (0, 1, 2, 3, ···) in accordance with a march test. In the first embodiment, the test control circuit 11 tests the memory cells in ascending order or descending order of the addresses of the RAM 21.

As illustrated in FIG. 18, the pattern sequence diagram illustrates the order of addresses in the RAM 21, and read data from and write data on the RAM 21. The horizontal axis of the pattern sequence diagram indicates the time along which the test of the RAM 21 illustrated in FIG. 8 progresses. The vertical axis of the pattern sequence diagram indicates the addresses of the RAM 21. "0" in the vertical axis of the pattern sequence diagram represents the minimum value "0" of the addresses of the RAM 21. The value of the addresses of the RAM 21 increases or decreases along the direction indicated by an arrow in the vertical axis of the pattern sequence diagram.

On the other hand, the timing chart illustrates changes of signals in the circuits of the RAM with BIST 10A illustrated in FIG. 8. The horizontal axis of the timing chart indicates the time along which the test of the RAM 21 progresses.

Regarding the vertical axis of the timing chart, WE represents a write enable signal output from the row address decoder circuit 23 illustrated in FIG. 8 to the RAM 21. AD represents an address data signal output from the row address decoder circuit 23 to the RAM 21. WD represents a write data signal output from the data register 22 to the RAM 21. LE represents a latch enable signal output from the LE register 28 illustrated in FIG. 8 to the DRCV selection signal generating circuit 30 illustrated in FIG. 8. The LE signal is a control signal for the first DRCV 14A and the second DRCV 14B illustrated in FIG. 8. EXP represents an expected value output from the expected value register 27 illustrated in FIG. 8 to the first DRCV 14A and the second DRCV 14B. en1 represents a DRCV selection signal output from the DRCV selection signal generating circuit 30 to the first DRCV 14A. en2 represents a DRCV selection signal output from the DRCV selection signal generating circuit 30 to the second DRCV 14B.

Next, time "0" in the pattern sequence diagram and the timing chart will be described.

At time "0" in the pattern sequence diagram, the address "0" of the RAM 21 is "W0". "W" of "W0" represents write. "0" of "W0" represents a data pattern "all 0". At time "0", the test control circuit 11 performs a process of writing data "all 0" in the address "0" of the RAM 21.

At time "0" in the timing chart, WE is "1". At time "0" in the timing chart, the test control circuit 11 performs a process of writing data on the RAM 21 by using the row address decoder circuit 23.

At time "0" in the timing chart, AD is "0". At time "0" in the timing chart, a write address of the RAM 21 is "0".

At time "0" in the timing chart, WD is "0". At time "0" in the timing chart, a write data pattern of the RAM 21 is "0".

At time "0" in the timing chart, LE is "0". At time "0" in the timing chart, comparison of an expected value using the first DRCV 14A and the second DRCV 14B is not performed.

At time "0" in the timing chart, EXP is "Don't care". At time "0" in the timing chart, comparison of an expected value using the first DRCV 14A and the second DRCV 14B is not performed, and thus the expected value is no object.

At time "0" in the timing chart, en1 is "0" and en2 is "0". At time "0" in the timing chart, comparison of an expected value using the first DRCV 14A and the second DRCV 14B is not performed, and thus data in the first DRCV 14A and the second DRCV 14B is not updated. In this way, control performed by the test control circuit 11 illustrated in the pattern sequence diagram and control performed by the test control circuit 11 illustrated in the timing chart are consistent with each other.

Next, time "T1" in the pattern sequence diagram and the timing chart will be described. At time "T1", a process of writing data "all 0" in the address "0" of the RAM 21 by the test control circuit 11 has been performed from the minimum address "0" to the maximum address "1023".

At time "T1" in the pattern sequence diagram, the address "0" of the RAM 21 is "R0". "R" of "R0" represents read. "0" of "R0" represents a data pattern "all 0". At time "T1", the test control circuit 11 compares the data "0" in the address "0" of the RAM 21 with the data "all 0" read out from the RAM 21.

At time "T1" in the timing chart, WE is "0". At time "T1" in the timing chart, the test control circuit 11 performs a process of reading data from the RAM 21 by using the row address decoder circuit 23.

At time "T1" in the timing chart, AD is "0". At time "T1" in the timing chart, a read address of the RAM 21 is "0".

At time "T1" in the timing chart, WD is "0". At time "T1" in the timing chart, an expected value data pattern of the RAM 21 is "0".

At time "T1" in the timing chart, LE is "1". At time "T1" in the timing chart, an expected value is compared with the data read out from the RAM 21 by using the first DRCV 14A and the second DRCV 14B.

At time "T1" in the timing chart, EXP is "0". The expected value register 27 receives WD "0" from the data register 22 with a delay of one cycle. EXP becomes "0", which is the value of WD at time "T1" in the timing chart, in the next cycle.

At time "T1" in the timing chart, en1 is "0" and en2 is "0". Comparison of an expected value using the first DRCV 14A and the second DRCV 14B is performed after one cycle of the cycle of "R0". Thus, after one cycle of the cycle "R0", en1 is "1" and en2 is "0". The read address AD is "0", and the first DRCV 14A is to receive a result of comparison between an expected value and the data read out from the RAM 21, and thus en1 is "1". On the other hand, the second DRCV 14B does not receive a result of comparison between an expected value and the data read out from the RAM 21, and thus en2 is "0". In this way, control performed by the test control circuit 11 illustrated in the pattern sequence diagram and control performed by the test control circuit 11 illustrated in the timing chart are consistent with each other.

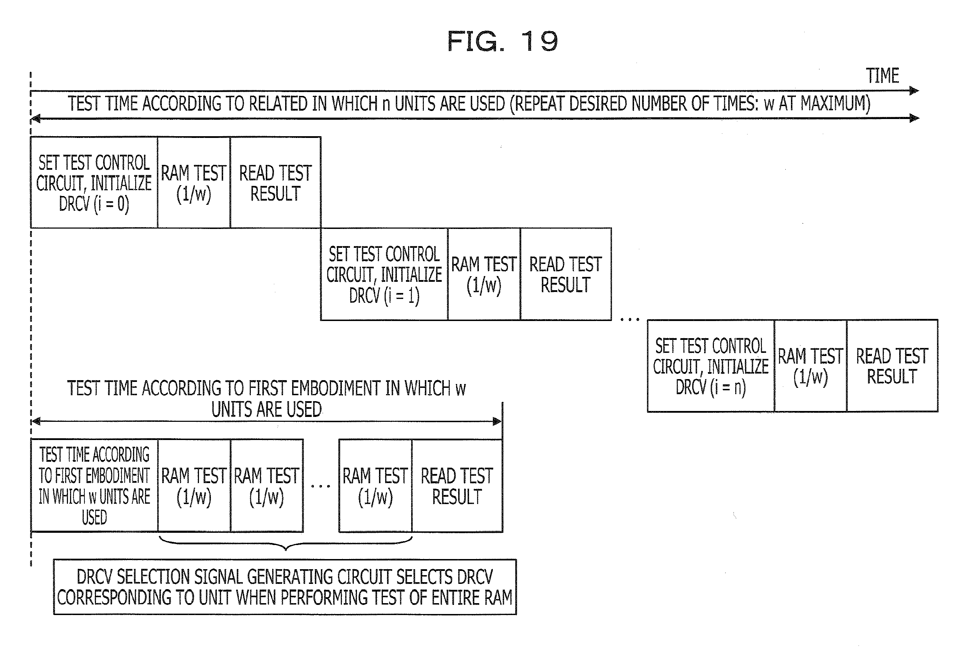

FIG. 19 is a diagram illustrating a comparison between test time for the RAM with BIST according to the related art and test time for the RAM with BIST 10A according to this embodiment. In FIG. 19, the horizontal axis indicates test time. In the above-described embodiment, a RAM cell plane of each bit is divided into two regions for the convenience of description, but the number of regions is not limited to two. In this comparative example, description will be given under the assumption that the number of regions in the plane for each bit is w.

The upper side of FIG. 19 illustrates the test time in a case where the number of regions is w according to the related art. The lower side of FIG. 19 illustrates test time in a case where the test method according to the first embodiment is used.

As illustrated in FIG. 19, in the RAM with BIST according to the related art, if a DRCV corresponding to a RAM cell plane is provided and if a redundant unit of bit is divided into w units, it is preferable to determine a redundancy division unit of bit having a defective cell. Thus, it is preferable that the test control circuit perform a test for determining whether or not a defective cell exists by limiting the redundancy division units by using a selector for controlling the redundant unit of bit, and repeat a test operation the number of times in accordance with the number of redundancy division units. The number of times corresponds to the number of times a unit is replaceable with a prepared replacement bit. The maximum value of the number of defective cells that may be replaced corresponds to the number replacement bits that are prepared. Thus, repeating replacement until the number of detections of a defective cell reaches the number of replacement bits enables sufficient detection of defective cells.

After the first test for 1/n of the RAM ends, the test control circuit initializes DRCVs by using a scan chain, and thus time to shift all the bits of a shift register constituting the RAM with BIST is taken. Thus, time for initializing the DRCVs is the same as time for reading out a test result of the RAM using the DRCVs. The time for initializing the DRCVs and the time for reading out a test result of the RAM using the DRCVs are proportional to the number of redundancy division units n of the RAM. Thus, in the RAM with BIST according to the related art, test time for determining whether or not a defective cell exists in all the w units in the RAM increases in proportional to the number of redundancy division units n.

Accordingly, it is understood that, if the number of initializations of the DRCVs and the number of times of reading out a test result of the RAM using the DRCVs increase, test time for determining whether or not a defective cell exists in all the w units in the RAM increases.

For example, it is assumed that 70000 clock pulses are set for one scan operation, and the operation speed of a processor at the scan operation is set to 100 MHz. In this case, the test time at the scan operation is 70000 x 10 ns = 700 µs, because the cycle time of 100 MHz is 10 µs.

Also, it is assumed that the number of all the clock pulses in a test of the RAM is 6144, and the operation speed of the processor is set to 3 GHz. In this case, the test time at the test of the RAM is 6144 x 0.33 ns = 2.05 µs, because the cycle time of 3 GHz is 0.33 ns. The test time at the scan operation is 700/2.05 = 341 times the test time at the test of the RAM.

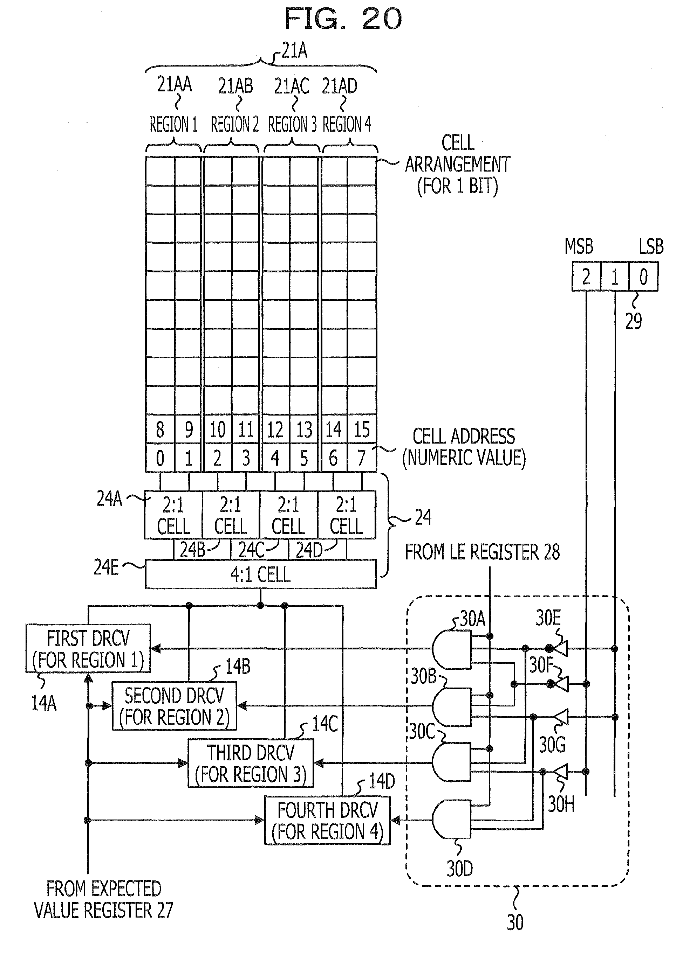

In the first embodiment, the RAM cell plane of each bit is divided into two regions. In a second embodiment, the RAM cell plane of each bit is divided into four regions. In FIG. 20, the same elements as those in the first embodiment are denoted by the same reference numerals, and the description thereof is omitted.

As illustrated in FIG. 20, the RAM with BIST 10A according to the second embodiment has a structure in which the RAM cell plane of each bit of the RAM 21 is divided into four regions. For example, the RAM cell plane 21A of the zero-th bit of the RAM 21 includes four regions, a region 21AA, a region 21AB, a region 21AC, and a region 21AD. The numbers assigned to the memory cells in the RAM cell plane 21A represent cell addresses. For example, the region 21AA includes memory cells to which cell addresses 0, 1, 8, 9 ··· are assigned.

The column address decoder circuit 24 includes column address decoder circuits 24A to 24D coupled to the respective regions 21AA to 21AD, and the column address decoder circuit 24E coupled to the output side of the column address decoder circuits 24A to 24D.

Each of the column address decoder circuits 24A to 24D reads out data stored in the memory cells of a corresponding one of the regions 21AA to 21AD, and outputs the data to the column address decoder circuit 24E.

The column address decoder circuit 24E is coupled to the column address decoder circuits 24A to 24D, and first to fourth DRCVs 14A to 14D. The column address decoder circuit 24E outputs the data read out from each of the column address decoder circuits 24A to 24D to the first to fourth DRCVs 14A to 14D.

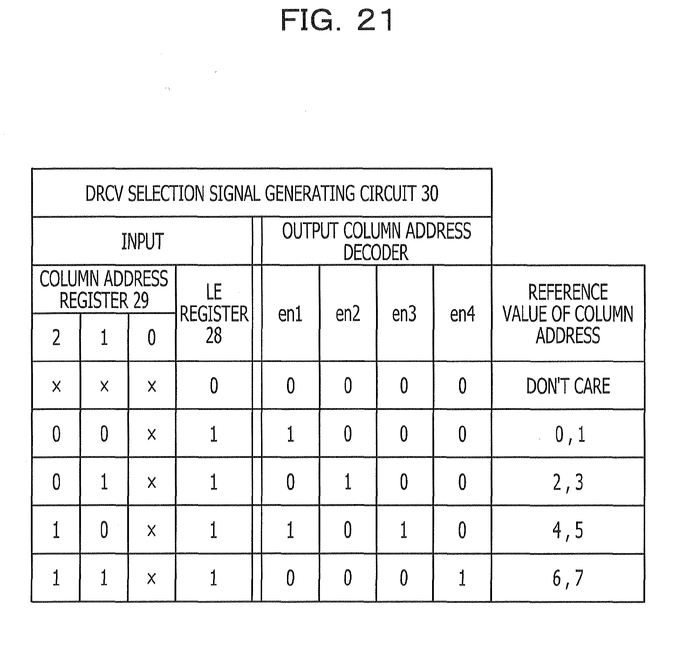

The column address register 29 stores column addresses in the RAM 21, in the form of a three-bit value (zero-th to second bits) using a binary number. In FIG. 20, the most significant bit is represented by MSB, and the least significant bit is represented by LSB. The correspondence between the MSB and LSB in the column address register 29 and the cell addresses will be described below with reference to FIG. 21.

The DRCV selection signal generating circuit 30 includes the circuits 30A to 30H, including an AND circuit.

As illustrated in FIG. 21, when the value of the LE register 28 is one, the DRCV selection signal generating circuit 30 outputs a selection signal to the first DRCV 14A when the value of the upper two bits in the column address register 29 is 00, outputs a selection signal to the second DRCV 14B when the value of the upper two bits in the column address register 29 is 01, outputs a selection signal to the third DRCV 14C when the value of the upper two bits in the column address register 29 is 10, and outputs a selection signal to the fourth DRCV 14D when the value of the upper two bits in the column address register 29 is 11.

When the value of the LE register 28 is zero, no test data is output, and thus no output is performed from any of the first to fourth DRCVs 14A to 14D.

The first DRCV 14A, the second DRCV 14B, the third DRCV 14C, or the fourth DRCV 14D compares a value supplied from the expected value register 27 with a value supplied from the column address decoder circuit 24E in accordance with the selection signal, and stores a comparison result.

With this configuration, the RAM cell plane of each bit may be divided into four regions.

In the first and second embodiments, the number of regions in a RAM cell plane of the RAM is two and four, respectively. Alternatively, the number of regions may be eight, sixteen, etc.

According to the above-described embodiments, a test for determining whether or not a defective cell exists in a RAM may be efficiently performed even if the number of redundancy division units increases.

## Claims

1. A semiconductor integrated circuit comprising:
a plurality of memory cells;
a plurality of receivers, each of the plurality of receivers being provided for a corresponding one of a plurality of units set by dividing the plurality of memory cells in a unit, and each of the plurality of receivers receiving a test result of the corresponding one of the plurality of units; and
a controller that reads out a plurality of test results from the plurality of receivers.

2. The semiconductor integrated circuit according to claim 1 comprising:
a redundant memory unit with which any one of the plurality of units is replaceable the redundant memory unit including a plurality of redundant memory cells,
wherein the controller replaces a unit, which included in the plurality of units, including a defective memory cell with the redundant memory unit.

3. A method of testing a semiconductor integrated circuit, the method comprising:
testing a plurality of memory cells, the testing being performed for each of a plurality of units set by dividing the plurality of memory cells in a unit;
receiving a plurality of test results corresponding to the plurality of units;
and
reading out the plurality of test results corresponding to the plurality of units.

4. The method for testing a semiconductor integrated circuit according to claim 3, wherein the semiconductor integrated circuit includes a redundant memory unit with which any one of the plurality of units is replaceable the redundant memory unit including a plurality of redundant memory cells, the method comprising:
replacing a unit, which included in the plurality of units, including a defective memory cell with the redundant memory unit.
